# EUROPEAN PATENT APPLICATION

(11) **EP 2 249 398 A1**
(43) Date of publication of application: **10.11.2010**
(21) Application number: 09714473.7
(22) Date of filing: 27.02.2009
(51) Int. Cl.: H01L 31/05, H01L 31/0224

(54) **SOLAR CELL MODULE**

(30) Priority: 28.02.2008 JP 2008048621
(71) Applicant: SANYO Electric Co., Ltd., Moriguchi-shi Osaka 570-8677 (JP)
(72) Inventor: MISHIMA, Takahiro, . (JP)
(74) Representative: Calderbank, Thomas Roger
(86) International application number: PCT/JP2009/053745
(87) International publication number: WO 2009/107804

(57) **Abstract**

In a solar cell module 100, a wiring member 11 has a plurality of recesses 11a formed in a facing surface S facing a resin adhesive 12. the resin adhesive 12 enters each of the plurality of recesses 11a and thereby exerts an anchor effect.

## Description

### TECHNICAL FIELD

The present invention relates to a solar cell module including a plurality of solar cells connected to each other through a wiring member.

### BACKGROUND ART

A solar cell is expected as a new energy source because the solar cell directly converts clean and inexhaustibly supplied sunlight into electricity.

Generally, each solar cell outputs power of only approximately several watts. Accordingly, when solar cells are used as a power source for a house, a building or the like, a solar cell module with a plurality of solar cells electrically connected to one another to enhance energy output is used.

The plurality of solar cells are electrically connected to each other through a wiring member. The wiring member is connected onto a connection electrode formed on the main surface of each solar cell.

Here, a method is proposed in which a resin adhesive is inserted between the wiring member and the connection electrode to bond the wiring member to the connection electrode, the resin adhesive being thermally cured at a temperature lower than the melting temperature of a solder (see JP-Y 3123842, for example). With the method, the influence of temperature change on a solar cell can be reduced as compared to the case where the wiring member is soldered to the connection electrode.

However, since the wiring member and the resin adhesive have different linear expansion coefficients, stress is generated in an interface between the wiring member and the resin adhesive due to temperature change of the solar cell module. Such stress is generated repeatedly under environment where the solar cell module is used. Accordingly, there is a risk that the wiring member may be detached from the resin adhesive.

The present invention has been made in view of the above circumstances. An object thereof is to provide a solar cell module capable of maintaining a favorable connection between a wiring member and a resin adhesive.

### DISCLOSURE OF THE INVENTION

An aspect of the present invention is summarized as a solar cell module comprising: a first solar cell and a second solar cell; a wiring member configured to electrically connect the first solar cell and the second solar cell to each other; and a resin adhesive provided between the first solar cell and the wiring member, wherein one member of the resin adhesive and the wiring member has a plurality of recesses formed in a facing surface facing the other member thereof, and the other member enters each of the plurality of recesses and thereby exerts an anchor effect.

According to the solar cell module described above, since the resin adhesive exerts an anchor effect, the adhesion between the wiring member and the resin adhesive is enhanced. This allows suppressing the detachment of the wiring member from the resin adhesive even when stress is generated in the interface between the wiring member and the resin adhesive due to temperature change of the solar cell module.

In the aspect of the prevent invention, the one member may be the wiring member, and a melting point of the wiring member may be higher than a melting point of the resin adhesive.

In the aspect of the prevent invention, the one member may be the resin adhesive, and a melting point of the resin adhesive may be higher than a melting point of the wiring member.

In the aspect of the prevent invention, each of the plurality of recesses may be bent inside the one member.

In the aspect of the prevent invention, one recess and another recess included in the plurality of recesses may be coupled to each other inside the one member.

In the aspect of the prevent invention, the one member may have a protrusion formed on the facing surface, and the protrusion may enter the other member and thereby may exert an anchor effect.

### BRIEF DESCRIPTION OF THE DRAWINGS

[Fig. 1] Fig. 1 is a side view of a solar cell module 100 according to an embodiment of the present invention.
[Fig. 2] Fig. 2 is a plan view of a solar cell string 1 according to the embodiment of the present invention.
[Fig. 3] Fig. 3 is a plan view of a solar cell 10 according to the embodiment of the present invention.
[Fig. 4] Fig. 4(a) is a cross-sectional view taken along the line A-A of Fig. 2. Fig. 4(b) is a cross-sectional view taken along the line B-B of Fig. 2.
[Fig. 5] Fig. 5 is a cross-sectional view showing a structure of a wiring member 11 according to a first embodiment of the present invention.
[Fig. 6] Fig. 6 is a cross-sectional view showing a structure of the wiring member 11 according to the first embodiment of the present invention.
[Fig. 7] Fig. 7 is a cross-sectional view showing a structure of a resin adhesive 12 according to a second embodiment of the present invention.
[Fig. 8] Fig. 8 is a plan view of a solar cell 10 according to an embodiment of the present invention.
[Fig. 9] Fig. 9 is a cross-sectional view of the solar cell 10 according to the embodiment of the present invention.
[Fig. 10] Fig. 10 is a view showing a die for forming recesses 11a according to the first embodiment of the present invention.
[Fig. 11] Fig. 11 is a cross-sectional view showing a structure of a wiring member 11 according to an embodiment of the present invention.

### BEST MODES FOR CARRYING OUT THE INVENTION

Next, an embodiment of the invention is described with reference to the drawings. In the following description of the drawings, identical or similar reference numerals are given to identical or similar components. However, the drawings are only schematic, thus it should be noted that the ratios of dimensions are not shown to scale. Accordingly, specific dimensions should be recognized in consideration of the following description. Also, there are inevitably included some portions of the drawings between which a dimensional relationship and/or a scale are inconsistent.

### [First Embodiment]

### (Structure of Solar Cell Module)

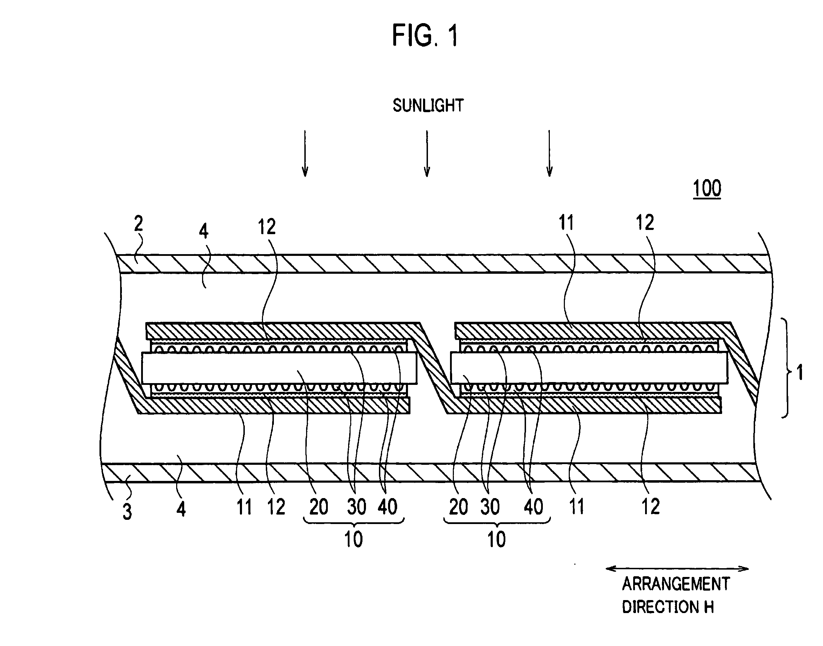

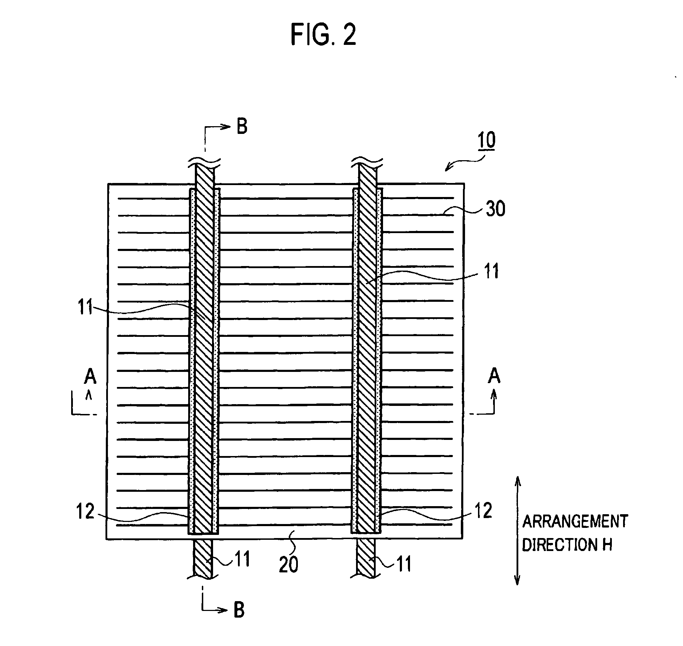

A schematic structure of a solar cell module 100 according to a first embodiment of the present invention is described with reference to Figs. 1 and 2. Fig. 1 is a side view of the solar cell module 100 and Fig. 2 is a plan view of a solar cell string 1 according to this embodiment.

The solar cell module 100 includes the solar cell string 1, a light-receiving-surface-side protection member 2, a back-surface-side protection member 3, and a sealant 4. The solar cell module 100 is configured in a way to seal the solar cell string 1 with the sealant 4 between the light-receiving-surface-side protection member 2 and the back-surface-side protection member 3.

The solar cell string 1 includes a plurality of solar cells 10, a wiring member 11, and a resin adhesive 12. The solar cell string 1 is configured in a way to connect the plurality of solar cells 10 to each other through the wiring member 11.

The plurality of solar cells 10 are arranged in an arrangement direction H. Each solar cell 10 includes a photoelectric conversion body 20, fine-line electrodes 30, and connection electrodes 40. The detailed structure of the solar cell 10 will be described later.

The wiring member 11 electrically connects the plurality of solar cells 10 to each other. To be more specific, the wiring member 11 is connected to connection electrodes 40 of one solar cell 10 and to connection electrodes 40 of a different solar cell 10 adjacent to the one solar cell 10. The wiring member 11 is connected to such connection electrodes 40 with the resin adhesive 12.

As the wiring member 11, conductive metal such as copper, silver, gold, tin, nickel, aluminum, or an alloy of these elements, or carbon in the form of a thin plate or twisted wire may be used. Moreover, the wiring member 11 may be subj ected to solder cover (tin cover) or aluminum cover. Here, the melting point of the wiring member 11 according to this embodiment is set at Th (°C).

The resin adhesive 12 is provided between the wiring member 11 and each connection electrode 40. The width of the resin adhesive 12 may be substantially equal to or smaller than that of the wiring member 11.

As the resin adhesive 12, not only an adhesive made of an acrylic resin or of a thermosetting resin made of highly flexible polyurethane or the like, but also a two-liquid reaction adhesive obtained by mixing a curing agent with an epoxy resin, an acrylic resin, or a urethane resin may be used, for example. Moreover, the resin adhesive 12 may include a plurality of conductive particles. As the conductive particles, nickel, silver, nickel coated with gold, copper coated with tin, or the like may be used. The resin adhesive 12 is preferably cured at a temperature equal to or lower than the melting point of solder, i.e., equal to or lower than approximately 200°C. Here, the melting point of the resin adhesive 12 according to this embodiment is set at Tj (°C). The melting point Th (°C) of the wiring member 11 is higher than the melting point Tj (°C) of the resin adhesive 12.

The light-receiving-surface-side protection member 2 is arranged at a light-receiving surface side of the sealant 4, and protects the front surface of the solar cell module 100. As the light-receiving-surface-side protection member 2, translucent and water-shielding glass, translucent plastic, or the like may be used.

The back-surface-side protection member 3 is arranged at a back surface side of the sealant 4, and protects the back surface of the solar cell module 100. As the back-surface-side protection member 3, a resin film such as a PET (Polyethylene Terephthalate) film, a laminated film with a structure in which Al foil is sandwiched between resin films, or the like may be used.

The sealant 4 seals the solar cell string 1 between the light-receiving-surface-side protection member 2 and the back-surface-side protectionmember 3. As the sealant 4, a resin which is translucent and made of EVA, EEA, PVB, silicon, urethane, acrylic, epoxy, or the like may be used.

Note that, an Al frame (not shown) may be installed at the outer periphery of the solar cell module 100 having the structure described above.

### (Structure of Solar Cell)

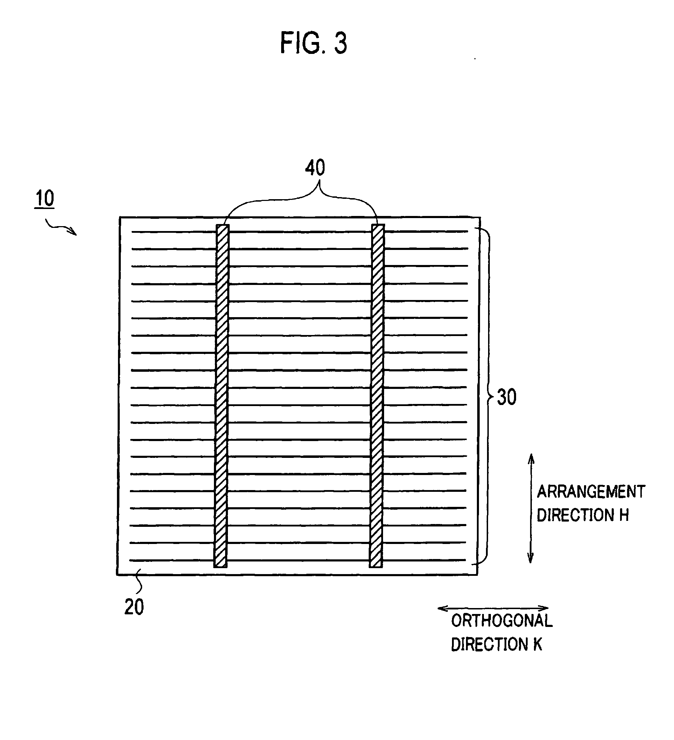

Next, a structure of the solar cell 10 is described with reference to Fig. 3. Fig. 3 is a plan view of the solar cell 10.

As shown in Fig. 3, the solar cell 10 includes the photoelectric conversion body 20, the fine-line electrodes 30 and the connection electrodes 40.

The photoelectric conversion body 20 includes a light-receiving surface and a back surface formed opposite the light-receiving surface. The photoelectric conversion body 20 generates light generation carriers by receiving light on the light-receiving surface. A light generation carrier denotes a hole and electron generated when the photoelectric conversion body 20 absorbs sunlight. The photoelectric conversion body 20 includes therein a semiconductor junction such as a pn junction or a pin junction. The photoelectric conversion body 20 may be made of a common semiconductor material including a crystalline semiconductor material such as monocrystalline Si or polycrystalline Si, or a compound semiconductor material such as GaAs or InP. Note that, the photoelectric conversion body 20 may have a so-called HIT structure in which a substantially intrinsic amorphous silicon layer is sandwiched between a monocrystalline silicon substrate and an amorphous silicon layer.

The fine-line electrodes 30 are collection electrodes for collecting carriers from the photoelectric conversion body 20. The fine-line electrodes 30 are formed on the photoelectric conversion body 20 in an orthogonal direction K substantially orthogonal to the arrangement direction H. The fine-line electrodes 30 can be formed by, for example, a resin conductive paste, a sintered conductive paste (ceramic paste), or the like by use of a coating method or a printing method.

Note that, as shown in Fig. 1, the fine-line electrodes 30 are formed in the same manner on the light-receiving surface and on the back surface of the photoelectric conversion body 20. The number of the fine-line electrodes 30 may be set appropriately in consideration of the size of the photoelectric conversion body 20, and the like. For example, when the dimension of the photoelectric conversion body 20 is approximately 100 mm square, approximately 30 fine-line electrodes 30 can be formed thereon.

The connection electrodes 40 are electrodes for the connection of the wiring member 11. The connection electrodes 40 are formed on the photoelectric conversion body 20 in the arrangement direction H. Accordingly, the connection electrodes 40 cross the plurality of fine-line electrodes 30. The connection electrodes 40 can be formed by a resin conductive paste, a sintered conductive paste (ceramic paste), or the like by use of the coating method or the printing method, as similar to the fine-line electrodes 30.

Note that, as shown in Fig. 1, the connection electrodes 40 are formed in the same manner on the light-receiving surface and on the back surface of the photoelectric conversion body 20. The number of the connection electrodes 40 may be set appropriately in consideration of the size of the photoelectric conversion body 20, and the like. For example, when the dimension of the photoelectric conversion body 20 is approximately 100 mm square, 2 connection electrodes 40 of approximately 1.5 mm width can be formed thereon.

### (Structures of Wiring Member and Resin Adhesive)

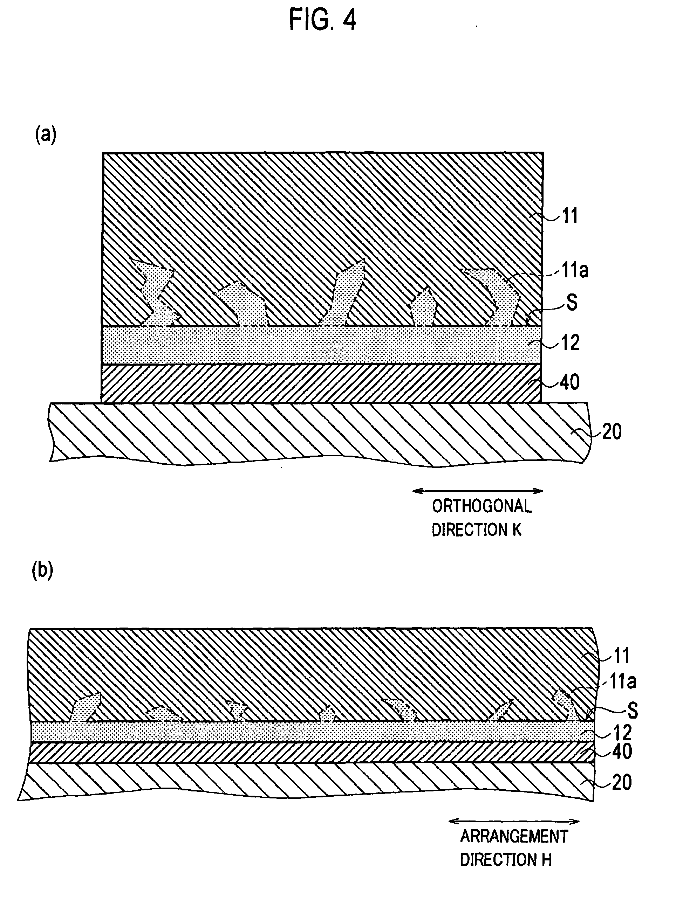

Next, structures of the wiring member 11 and the resin adhesive 12 are described with reference to Fig. 4. Fig. 4 (a) is a cross-sectional view taken along the line A-A of Fig. 2. Fig. 4(b) is a cross-sectional view taken along the line B-B of Fig. 2.

The wiring member 11 has a plurality of recesses 11a formed in a facing surface S facing the resin adhesive 12. As shown in Fig. 4, each of the plurality of recesses 11a is in the form of a longitudinal hole. The plurality of recesses 11a may be arranged regularly at equal intervals, or may be arranged irregularly. Each of the plurality of recesses 11a has an irregular structure, and is bent inside the wiring member 11.

The resin adhesive 12 enters each of the plurality of recesses 11a, and thereby exerts an anchor effect on the wiring member 11.

### (Method of Forming Plurality of Recesses)

Next, description is given of an example of a method of forming the plurality of recesses 11a.

First, SnAgCu solder melted at a temperature of approximately 220°C is mixed with a glass fiber chip of 10 µm diameter and 30 to 100 µm length at a ratio of approximately 8 wt%.

Next, copper foil (core) of 200 µm thickness is immersed in the melted SnAgCu solder to form a solder layer (covering layer) on the surfaces of the copper foil. Subsequently, the solder layer is cooled and thereby solidified.

Then, glass powder mixed in the solder layer is selectively etched by using hydrogen fluoride aqueous solution (10 wt%). Thereby, the plurality of recesses 11a are formed in the solder layer.

### (Method of Manufacturing Solar Cell Module)

Next, description is given of an example of a method of manufacturing the solar cell module 100 according to this embodiment.

First, an epoxy thermosetting silver paste is arranged with a pattern shown in Fig. 3 on the light-receiving surface and back surface of the photoelectric conversion body 20 by using a printing method such as a screen printing method. Thereafter, the silver paste is heated under a predetermined condition and cured. Thereby, the fine-line electrodes 30 and the connection electrodes 40 are formed.

Next, the resin adhesive 12 and the wiring member 11 having the plurality of recesses 11a are sequentially disposed on the connection electrodes 40. Then, by using a heater block heated up to a temperature equal to or higher than the melting point Tj (°C) of the resin adhesive 12 and lower than the melting point Th (°C), the wiring member 11 is heated while being pressed toward the photoelectric conversion body 20. In this event, the resin adhesive 12 is melted and flows into the plurality of recesses 11a. Here, the melting point Th (°C) of the wiring member 11 is higher than the melting point Tj (°C) of the resin adhesive 12, and thus the wiring member 11 is not melted. With the above processes, the solar cell string 1 is fabricated.

Subsequently, a stacked body is made by sequentially stacking an EVA (sealant 4) sheet, the solar cell string 1, an EVA (sealant 4) sheet, and a PET sheet (back-surface-side protection member 3) on a glass substrate (light-receiving-surface-side protection member 2).

Thereafter, the stacked body is heated to cross-link EVA. With the above processes, the solar cell module 100 is fabricated.

### (Effects and Advantages)

In the solar cell module 100 according to this embodiment, the wiring member 11 has the plurality of recesses 11a formed in the facing surface S facing the resin adhesive 12. The resin adhesive 12 enters each of the plurality of recesses 11a, and thereby exerts an anchor effect.

Since the resin adhesive 12 exerts an anchor effect on the wiring member 11 in this manner, the adhesion between the wiring member 11 and the resin adhesive 12 is enhanced. This allows suppressing the detachment of the wiring member 11 from the resin adhesive 12 even when stress is generated in an interface between the wiring member 11 and the resin adhesive 12 due to temperature change of the solar cell module 100. Accordingly, the reliability of an electrical connection between the solar cell 10 and the wiring member 11 through the resin adhesive 12 can be enhanced. As a consequence, it is possible to ensure the high productivity and to suppress a decrease in the energy output of the solar cell module 100 at the same time.

Further, in this embodiment, each of the plurality of recesses 11a is bent inside the wiring member 11. This allows increasing an anchor effect exerted by the resin adhesive 12.

Further, in this embodiment, the melting point Th (°C) of the wiring member 11 is higher than the melting point Tj (°C) of the resin adhesive 12. This allows the resin adhesive 12 to smoothly enter the plurality of recesses 11a formed in the wiring member 11.

### [Modification 1 of First embodiment]

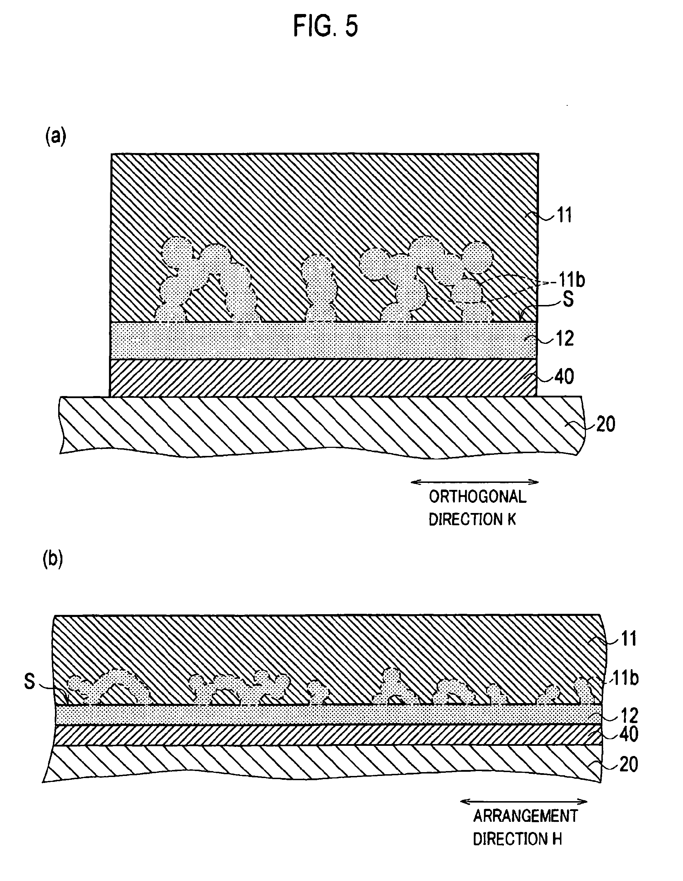

Next, Modification 1 of the first embodiment is described with reference to Fig. 5. Fig. 5 is a cross-sectional view showing structures of the wiring member 11 and the resin adhesive 12 according to this modification.

The wiring member 11 has a plurality of recesses 11b formed in the facing surface S facing the resin adhesive 12. As shown in Fig. 5, the plurality of recesses 11b are arranged in an orthogonal direction K and an arrangement direction H.

Each of the plurality of recesses 11b has a structure of an array of spherical small holes. Moreover, one recess 11b is coupled to another recess 11b inside the wiring member 11.

The resin adhesive 12 enters each of the plurality of recesses 11b, and thereby exerts an anchor effect on the wiring member 11.

Note that, in this modification, the melting point Th (°C) of the wiring member 11 is also higher than the melting point Tj (°C) of the resin adhesive 12.

### (Method of Forming Plurality of Recesses)

Next, description is given of an example of a method of forming the plurality of recesses 11b.

First, aluminum powder is mixed with foaming agent powder (such as TiH2) at a ratio of approximately 2 wt% to fabricate mixed powder.

Next, the mixed powder of approximately 50 µm thickness is thermally pressure-bonded at approximately 500°C to the surfaces of copper foil (core) of 200 µm thickness to form an aluminum layer (covering layer).

Then, thermal treatment is performed thereon at a temperature equal to or higher than the melting point of aluminum (approximately 660°C) to cause the foaming agent powder to generate hydrogen gas. Accordingly, a plurality of holes are coupled to each other and a recess 11b is thereby formed. Such a recess 11b is formed in plurality in the aluminum layer.

### (Effects and Advantages)

In this modification, one recess 11b and another recess 11b included in the plurality of recesses 11b are coupled to each other inside the wiring member 11.

Since the recesses 11b are shaped in the form of a tunnel by being coupled to each other in this manner, an anchor effect exerted by the resin adhesive 12 can be further increased.

Moreover, since each recess 11b has a structure of an array of spherical small holes, a contact area between the wiring member 11 and the resin adhesive 12 can be enlarged.

As a consequence, the detachment of the wiring member 11 from the resin adhesive 12 can be further suppressed.

### [Modification 2 of First Embodiment]

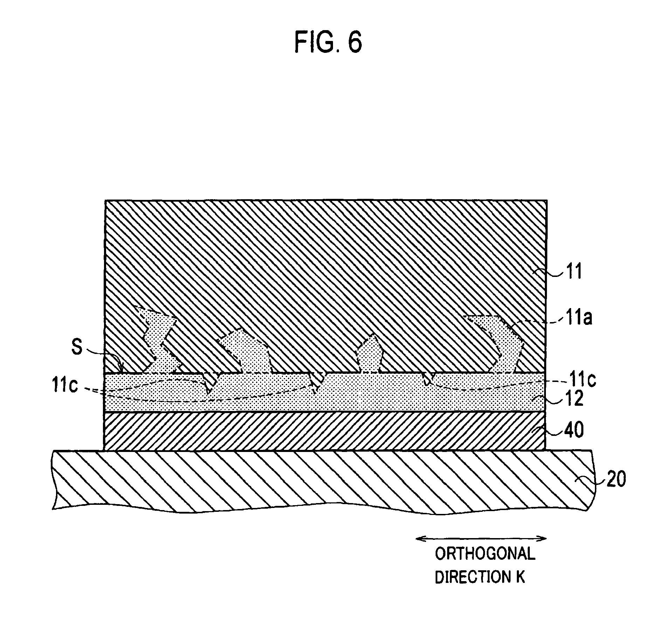

Next, Modification 2 of the first embodiment is described with reference to Fig. 6. Fig. 6 is a cross-sectional view showing a structure of the wiring member 11 according to this modification.

The wiring member 11 according to this modification has a plurality of protrusions 11c formed on the facing surface S facing the resin adhesive 12. The plurality of protrusions 11c are arranged in the orthogonal direction K and the arrangement direction H. Each of the plurality of protrusions 11c bites into the inside of the resin adhesive 12, and thereby exerts an anchor effect.

The plurality of protrusions 11c can be formed by subjecting the facing surface S of the wiring member 11 to a mechanical process or by shaping the wiring member 11 by using a die having a plurality of recesses corresponding to the plurality of protrusions 11c.

Note that, in this modification, the melting point Th (°C) of the wiring member 11 is also higher than the melting point Tj (°C) of the resin adhesive 12.

### (Effects and Advantages)

In this modification, the wiring member 11 further has the plurality of protrusions 11c formed on the facing surface S facing the resin adhesive 12. Each of the plurality of protrusions 11c bites into the inside of the resin adhesive 12, and thereby exerts an anchor effect. Thus, the detachment of the wiring member 11 from the resin adhesive 12 can be further suppressed.

### [Second Embodiment]

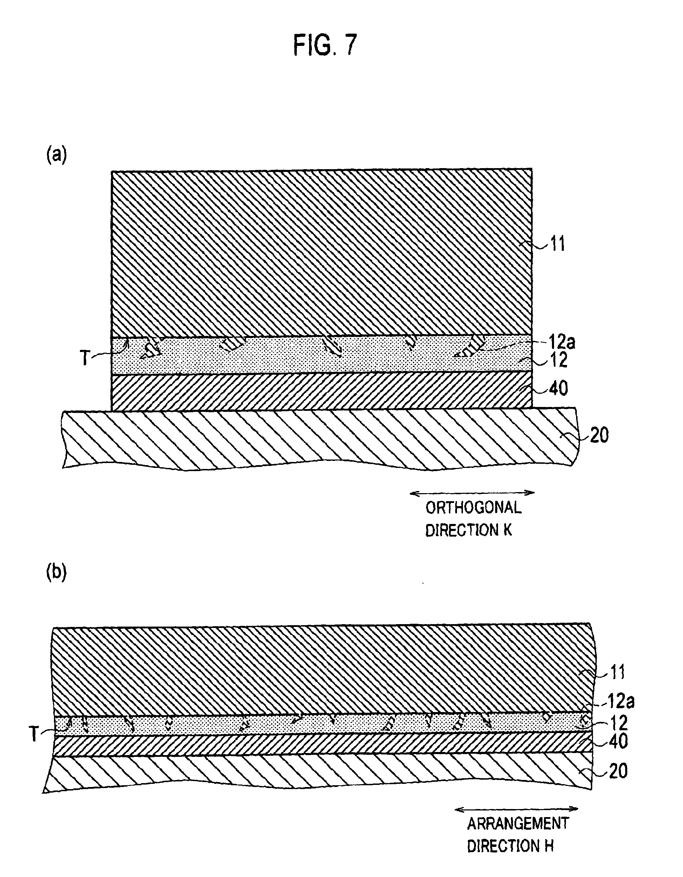

Next, a second embodiment of the present invention is described with reference to Fig. 7. Figs. 7(a) and 7(b) are cross-sectional views each showing structures of a wiring member 11 and a resin adhesive 12 according to this embodiment.

This embodiment is different from the first embodiment in that the resin adhesive 12 has a plurality of recesses 12a. The others are the same as the first embodiment, and therefore the difference is mainly described.

The resin adhesive 12 has the plurality of recesses 12a formed in a facing surface T facing the wiring member 11. As shown in Fig. 7, each of the plurality of recesses 12a is in the form of a longitudinal hole. The plurality of recesses 12a may be arranged regularly at equal intervals, or may be arranged irregularly.

Each of the plurality of recesses 12a has an irregular structure, and is bent inside the resin adhesive 12. The plurality of recesses 12a described above may be formed by subjecting the facing surface T of the resin adhesive 12 to a mechanical process (such as press work).

The wiringmember 11 enters each of the plurality of recesses 12a, and thereby exerts an anchor effect on the resin adhesive 12.

Here, the melting point Tj (°C) of the resin adhesive 12 is higher than the melting point Th (°C) of the wiring member 11 in this embodiment. Thus, in a step of connecting the wiring member 11 to the connection electrodes 40, a heater block heated to a temperature equal to or higher than the melting point Th (°C) of the wiring member 11 and lower than the melting point Tj (°C) is used.

Specifically, first of all, the wiring member 11 is heated while being pressed toward the photoelectric conversion body 20 by using the heater block heated up to a temperature equal to or higher than the melting point Th (°C) and lower than the melting point Tj (°C). Thereby, the wiring member 11 is melted and flows into the plurality of recesses 12a. On the other hand, the resin adhesive 12 is not melted since the melting point Tj (°C) of the resin adhesive 12 is higher than the melting point Th (°C) of the wiring member 11.

Next, the resin adhesive 12 is melted by heating the heater block up to the melting point Tj (°C) of the resin adhesive 12. Thereby, the wiring member 11 is connected to the connection electrodes 40 through the resin adhesive 12.

The other manufacturing steps are the same as those of the first embodiment.

### (Effects and Advantages)

In the solar cell module 100 according to this embodiment, the resin adhesive 12 has the plurality of recesses 12a formed in the facing surface T facing the wiring member 11. The wiring member 11 enters each of the plurality of recesses 12a, and thereby exerts an anchor effect.

Since the wiring member 11 exerts an anchor effect on the resin adhesive 12 in this manner, the adhesion between the wiring member 11 and the resin adhesive 12 is enhanced. This allows suppressing the detachment of the wiring member 11 from the resin adhesive 12 even when stress is generated in an interface between the wiring member 11 and the resin adhesive 12 due to temperature change of the solar cell module 100.

Moreover, in this embodiment, the melting point Tj (°C) of the resin adhesive 12 is higher than the melting point Th (°C) of the wiring member 11. This allows the wiring member 11 to smoothly enter the plurality of recesses 12a formed in the resin adhesive 12.

### (Other Embodiments)

The present invention has been described by way of the above embodiment. However, it should not be understood that the description and drawings constituting a part of the disclosure limit the present invention. Various alternative embodiments, examples, and operational techniques will be apparent for those skilled in the art from the disclosure.

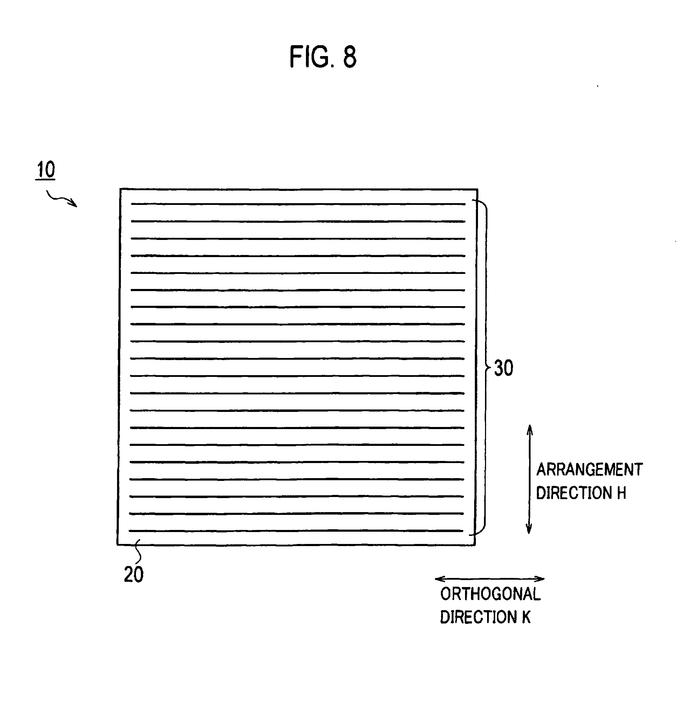

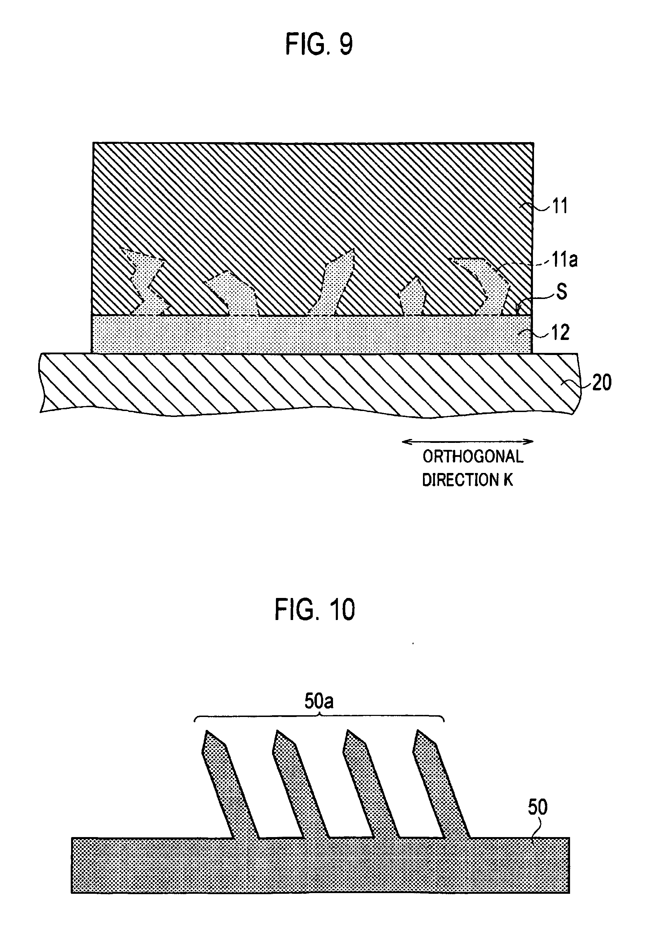

For example, in the above embodiments, description has been given of the configuration in which the solar cell 10 includes the connection electrodes 40. However, the solar cell 10 does not necessarily have to include the connection electrodes 40. To be more specific, as shown in Fig. 8, only the plurality of fine-line electrodes 30 may be formed on the main surface of the photoelectric conversion body 20. In this case, as shown in Fig. 9, the wiring member 11 is disposed on the solar cell 10 with the resin adhesive 12 interposed therebetween. Here, an electrical connection between the wiring member 11 and the solar cell 10 is established by causing each of the plurality of fine-line electrodes 30 to dig into the wiring member 11.

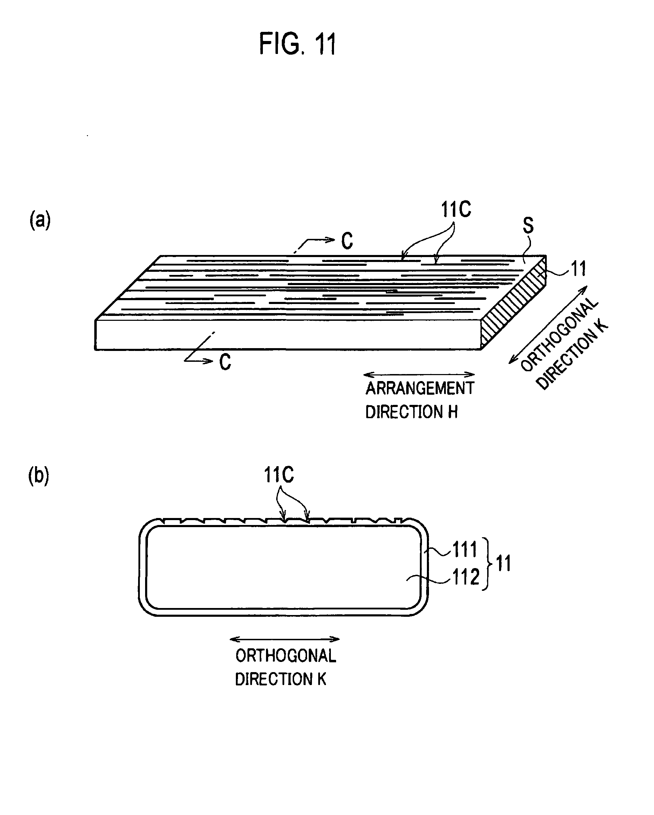

Further, in the above embodiment, description has been given of the example in which each of the plurality of recesses 11a formed in the facing surface S of the wiring member 11 is in the form of a longitudinal hole. However, the shape of each of the plurality of recesses 11a is not limited to this. For example, as shown in Fig. 11, each of the plurality of recesses may be in the form of a groove. Fig. 11(a) is a perspective view in which the wiring member 11 is viewed from the facing surface S side. Fig. 11(b) is a cross-sectional view taken along the line C-C of Fig. 11(a).

As shown in Fig. 11(a), a plurality of recesses 11c are formed in a longitudinal direction of the wiring member 11 (i.e., the arrangement direction H). To be more specific, as shown in Fig. 11(b), the plurality of recesses 11c are formed in a covering layer 112 which is made of solder or the like and formed on a surface of a core 111 made of copper foil or the like. The plurality of recesses 11c described above can be formed by rubbing the facing surface S of the wiring member 11 in the longitudinal direction by using sandpaper (with roughness of around #240, for example) or the like.

The wiring member 11 with the above structure allows the resin adhesive 12 to enter the plurality of recesses 11a, and thus allows the resin adhesive 12 to have an anchor effect on the wiring member 11. Note that, the plurality of recesses 11c may be formed in a direction different from the longitudinal direction of the wiring member 11. Moreover, the plurality of recesses 11c may have a depth enough to reach the inside of the copper foil (core).

Further, in the first embodiment, each of the plurality of recesses 11a is bent inside the wiring member 11. Alternatively, each of the plurality of recesses 11a may be in the form of a straight line. The plurality of recesses 11a described above can be formed by causing a plurality of protrusions 50a included in a die 50 shown in Fig. 10 to dig into the wiring member 11, for example.

Further, in the first embodiment, the resin adhesive 12 is filled up in each of the plurality of recesses 11a. However, the resin adhesive 12 has only to be partially filled in each of the plurality of recesses 11a.

Further, in the second embodiment, the resin adhesive 12 may have protrusions formed on the facing surface T and biting into the wiring member 11.

Further, in the above embodiment, the fine-line electrodes 30 and the connection electrodes 40 are formed on the back surface of the photoelectric conversion body 20. Alternatively, the electrodes may be formed to cover the entire back surface. The present invention does not limit the shape of the electrodes formed on the back surface of the photoelectric conversion body 20.

Further, in the above embodiment, the fine-line electrode 30 is formed in the orthogonal direction to have a line shape. However, the shape of the fine-line electrode 30 is not limited to this. For example, a plurality of fine-line electrodes 30 in the form of wavy lines may cross in the form of lattice.

As described, it goes without saying that the present invention includes various embodiments and the like not listed herein. Accordingly, the technical scope of the present invention is to be defined only by the specific subject matters of the invention according to the scope of the invention defined appropriately from the above description.

### Examples

Hereinafter, examples of the solar cell module according to the present invention are specifically described. The present invention is not limited to the following examples, and may be appropriately modified and implemented without changing the gist of the present invention.

### (Example 1)

First, a plurality of recesses in the form of longitudinal holes were formed in a surface of a wiring member. To be more specific, the die (see Fig. 10) having the plurality of protrusions (ϕ 18 µm, 30 µm length, 70 degrees inclination angle, 1 mm pitch) was pressed a plurality of times against a solder layer of 30 µm thickness formed on a flat surface of copper foil of 1.5 mm width and 0.2 mm thickness. Thereby, the plurality of recesses in the form of longitudinal holes were formed in the surface of the wiring member at a pitch of 30 to 50 µm. Here, each of the plurality of recesses in the form of a longitudinal hole was formed in a random direction by rotating the die with respect to the wiring member every time the die was pressed thereagainst.

Next, on the light-receiving surface and back surface of a photoelectric conversion body with a dimension of 100 mm square, an epoxy thermosetting silver paste was printed in a lattice pattern (see Fig. 3) by using a screen printing method to form thereon fine-line electrodes and connection electrodes.

Subsequently, an epoxy resin adhesive containing silver particles was applied to the connection electrodes formed on the light-receiving surface of one solar cell and the connection electrodes formed on the back surface of a different solar cell adjacent to the one solar cell. Then, the wiring member having the plurality of recesses in the form of longitudinal holes was disposed on the epoxy resin adhesive containing silver particles. Thereafter, the wiring member was heated by using a heater block to connect the wiring member to the connection electrodes.

A solar cell string fabricated in the above manner was sealed with EVA between glass and a PET film to fabricate a solar cell module according to Example 1.

### (Example 2)

In Example 2, a plurality of recesses in the form of grooves were formed in a surface of a wiring member. To be more specific, in a solder layer of 30 µm thickness formed on a flat surface of copper foil of 1. 5 mm width and 0. 2 mm thickness, the plurality of recesses in the form of grooves were formed in a longitudinal direction of the wiring member by using a belt sander equipped with #240 polishing paper (see Fig. 11).

In this event, the plurality of recesses in the form of grooves were made to have a uniform shape by devising a method of holding the wiring member. To be more specific, the belt sander was pressed against the surface of the wiring member (approximately 200 mm length) in the state where the wiringmember was fitted into a groove (1.6 mm width, 150 µm depth) formed in a work surface of a processing table and was vacuum-sucked. Thereby, the recesses having the uniform shape were formed.

Other processes were the same as those of Example 1.

### (Comparative Examples 1 and 2)

Solar cell modules according to Comparative Examples 1 and 2 were each fabricated by using a wiring member in the form of a flat plate without forming a plurality of recesses. Other processes were the same as those of Example 1.

### (Temperature Cycle Test)

Next, the solar cell modules according to Examples 1 and 2 and Comparative Examples 1 and 2 were subjected to a temperature cycle test by use of a constant temperature oven.

Here, the temperature cycle test was conducted in accordance with the regulations of JIS C 8917. Specifically, the samples held in the constant temperature oven were increased in temperature from 25°C up to 90°C in 45 minutes, then kept at this temperature for 90 minutes, then decreased in temperature down to -40°C in 90 minutes, then kept at this temperature for 90 minutes, and then increased in temperature up to 25°C in 45 minutes. The above steps were taken as one cycle (6 hours) and 200 cycles were carried out.

Table 1 shows a result of measuring the energy outputs of the solar cell modules according to Example 1 and Comparative Example 1 before and after the test. Table 2 shows a result of measuring the energy outputs of the solar cell modules according to Example 2 and Comparative Example 2 before and after the test. Values of Tables 1 and 2 are obtained by taking their output values before the test as a reference.

**[Table 1]**

| | Pmax before test | Pmax after test |
|---|---|---|
| Example 1 | 1.000 | 1.000 |
| Comparative Example 1 | 1.000 | 0.998 |

**[Table 2]**

| | Pmax before test | Pmax after test |
|---|---|---|
| Example 2 | 1.000 | 0.990 |
| Comparative Example 2 | 1.000 | 0.975 |

As shown in Tables 1 and 2, after the temperature cycle test, higher energy outputs could be obtained in Examples 1 and 2 than those in Comparative Examples 1 and 2. In other words, the solar cell modules according to Examples 1 and 2 could resist stress repeatedly generated in an interface between the wiring member and the resin adhesive due to periodical temperature change. This is because the resin adhesive entered each of the plurality of recesses and exerted an anchor effect, and thereby the adhesion strength between the wiring member and the resin adhesive could be enhanced.

On the other hand, in each of Comparative Examples 1 and 2, the resin adhesive did not exert an anchor effect since the wiring member had no recess. Accordingly, the adhesion between the wiring member and the resin adhesive was reduced due to stress repeatedly generated in an interface between the wiring member and the resin adhesive, and consequently the energy output was reduced.

### INDUSTRIAL APPLICABILITY

The present invention can provide a solar cell module capable of maintaining a favorable connection between a wiring member and a resin adhesive, and is thus advantageous in the field of solar power generation.

## Claims

1. A solar cell module comprising:
a first solar cell and a second solar cell;
a wiring member configured to electrically connect the first solar cell and the second solar cell to each other; and
a resin adhesive provided between the first solar cell and the wiring member, wherein
one member of the resin adhesive and the wiring member has a plurality of recesses formed in a facing surface facing the other member thereof, and
the other member enters each of the plurality of recesses and thereby exerts an anchor effect.

2. The solar cell module according to claim 1, wherein
the one member is the wiring member, and
a melting point of the wiring member is higher than a melting point of the resin adhesive.

3. The solar cell module according to any one of claims 1 and 2, wherein
the one member is the wiring member, and
each of the plurality of recesses is in the form of a groove.

4. The solar cell module according to claim 1, wherein
the one member is the resin adhesive, and
a melting point of the resin adhesive is higher than a melting point of the wiring member.

5. The solar cell module according to claim 1, wherein each of the plurality of recesses is bent inside the one member.

6. The solar cell module according to claim 1, wherein one recess and another recess included in the plurality of recesses are coupled to each other inside the one member.

7. The solar cell module according to claim 1, wherein
the one member has a protrusion formed on the facing surface, and
the protrusion enters the other member and thereby exerts an anchor effect.
